# EUROPÄISCHE PATENTSCHRIFT

(11) **EP 0 463 440 B1**
(45) Veröffentlichungstag und Bekanntmachung des Hinweises auf die Patenterteilung: **03.05.1995**
(21) Anmeldenummer: 91109428.2
(22) Anmeldetag: 08.06.1991
(51) Int. Cl.: G01S 17/02, E03C 1/00, H03K 17/945

(54) **Verfahren zum Betreiben einer Schaltungsanordnung für eine berührungslos gesteuerte Sanitärarmatur und Schaltungsanordnung zur Durchführung dieses Verfahrens**
Method of driving a circuit arrangement for a contactless controlled sanitary device and circuit for carrying out this method
Méthode d'utilisation de circuit destiné à commander sans contact une armature sanitaire et circuit pour la réalisation de cette méthode

(30) Priorität: 22.06.1990 DE 4019927
(43) Veröffentlichungstag der Anmeldung: 02.01.1992
(73) Patentinhaber: HANSA METALLWERKE AG, D-70567 Stuttgart (DE)
(72) Erfinder: Kunkel, Horst, W-7000 Stuttgart 31 (DE)
(74) Vertreter: Ostertag, Ulrich

(56) Entgegenhaltungen:
- WO-A-89/11710
- DE-B- 2 836 734

## Beschreibung

Die Erfindung betrifft ein Verfahren zum Betreiben einer Schaltungsanordnung für eine berührungslos gesteuerte Sanitärarmatur mit einem Sender, mit einem Empfänger, auf welchen vom Sender ausgesandte Strahlung an einem Objekt zurückreflektierbar ist, und mit einer dem Empfänger nachgeschalteten Auswertschaltung, die ein Ausgangssignal abgibt, wenn das vom Empfänger abgegebene Signal einen bestimmten Schwellwert übersteigt.

Bei Schaltungsanordnungen dieser Art besteht immer das Problem, daß zwischen der Reflexion der vom Sender ausgesandten Strahlung an stationär vorhandenen Objekten, beispielsweise an Waschtischen, und der Reflexion am Benutzer bzw. Körperteilen des Benutzers unterschieden werden muß. Die Reflexion an den stationär vorhandenen Gegenständen darf nicht zum Auslösen der Sanitärarmatur, also zum Wasserfluß führen, da dann der Wasserfluß nicht mehr beendet würde. Verringert man die Empfindlichkeit der Schaltungsanordnung so weit, daß stationär vorhandene Objekte mit Sicherheit auch im Verlaufe der Zeit nicht zur Auslösung führen, in der sich sowohl die Oberflächenbeschaffenheit der stationär vorhandenen Objekte als auch die elektrischen Komponenten der Schaltungsanordnung verändern können, so müssen verhältnismäßig große Totzonen eingehalten werden. In diesen spricht die Schaltungsanordnung auch auf den Benutzer nicht mehr an.

Bei einer bekannten, Schaltungsanordnung der eingangs genannten Art, die in der DE-C-34 08 261 beschrieben ist, wird dieses Problem wie folgt angegangen: Es ist ein Langzeit-Mittelwertbildner vorgesehen, welcher über verhältnismäßig große Zeitspannen hinweg einen Langzeit-Mittelwert des Empfangssignals bildet. Dieses Langzeit-Signal ist dann repräsentativ für diejenige Strahlung, die von stationär vorhandenen Objekten reflektiert wird. Der momentane Wert des Empfangssignales wird nunmehr mit dem Langzeit-Signal verglichen; nur wenn sich gegenüber diesem eine bestimmte minimale Abweichung ergibt, löst die bekannte Schaltungsanordnung aus. Mit diesen Maßnahmen läßt sich sowohl ein "Selbstabgleich" der Schaltungsanordnung auf eine bestimmte Umgebung als auch eine Nachjustierung gegen kontinuierliche Veränderungen der Umgebung sowie gegen innere Alterungsvorgänge erzielen. Nachteilig ist jedoch, daß die Schaltungsanordnung zur Bildung des Langzeit-Mittelwertes ständig bestromt werden muß. Hiermit ist ein Energieverbrauch verbunden, der jedenfalls dann nicht mehr tragbar ist, wenn die Schaltungsanordnung aus einer Batterie gespeist werden soll.

Aufgabe der vorliegenden Erfindung ist es, ein Verfahren sowie eine Schaltungsanordnung der eingangs genannten Art anzugeben, bei welchen eine automatische Anpassung auf die jeweiligen örtlichen Gegebenheiten unter Erzielung einer maximalen Empfindlichkeit bei gleichzeitig geringem Energiebedarf erreicht wird.

Diese Aufgabe wird erfindungsgemäß bei dem eingangs genannten Verfahren dadurch gelöst, daß bei der Erstinstallation der Schaltungsanordnung automatisch ein Initialisierungsvorgang eingeleitet und durchgeführt wird, in dessen Verlauf die Leistung des Senders progessiv gesteigert wird, bis durch an einem stationär vorhandenen Objekt reflektierte Strahlung die Auswertschaltung anspricht, daß daraufhin die Leistung des Senders wieder etwas reduziert wird und danach bei dieser verminderten Leistung des Senders in den Normalbetrieb übergegangen wird.

Erfindungsgemäß wird also mit dem "Initialisierungsvorgang" ein besonderer Betriebsmodus der Schaltungsanordnung geschaffen, welcher dem eigentlichen Normalbetrieb vorgeschaltet ist: Die Umgebung der Schaltungsanordnung wird gewissermaßen "abgetastet"; die Schaltungsanordnung probiert selbsttätig diejenige Senderleistung aus, bei welcher die jeweils vorhandenen stationären Objekte zu einem Auslösen der dem Empfänger nachgeschalteten Auswertschaltung führen. Dies ist diejenige Senderleistung, die im Betrieb gerade nicht mehr erreicht werden darf. Aus diesem Grunde fährt die Schaltungsanordnung automatisch wieder auf eine etwas geringere Senderleistung zurück. Erst dann wird in den Normalbetrieb der Schaltungsanordnung übergegangen. Der Normalbetrieb spielt sich, wie der Name sagt, genau wie beim Stande der Technik ab: Tritt ein Benutzer an die Sanitärarmatur heran, so wird an ihm ein Teil der vom Sender ausgesandten Strahlung auf den Empfänger zurückreflektiert. Dies führt zu einem Ausgangssignal der dem Empfänger nachgeschalteten Auswertschaltung, wenn das vom Empfänger abgegebene Signal einen bestimmten Schwellwert übersteigt. Die erfindungsgemäß erreichte Empfindlichkeit der Anordnung vermeidet Toträume weitgehend, in denen an und für sich ein Ansprechen auf Objekte erwünscht wäre, dies aber aus Sicherheitsgründen vermieden werden muß.

Die Maßnahmen, mit denen die Erfindung eine Fehlauslösung durch stationär vorhandene Objekte unterbindet, finden nicht kontinuierlich während des gesamten Betriebes der Schaltungsanordnung statt sondern gehen, wie geschildert, dem Normalbetrieb voraus. Der Normalbetrieb kann daher mit allen energiesparenden bekannten Maßnahmen, insbesondere also mit getaktetem Sender erfolgen.

Der bei diesem Initialisierungsvorgang ermittelte Wert der Leistung des Senders sollte mit einem vorgegebenen Toleranzbereich verglichen werden, innerhalb dessen sich die Leistung bei normaler Funktion der Schaltungsanordnung befinden muß. Wird während des Initialisierungsvorganges keine Senderleistung erreicht, die innerhalb des Toleranzbereiches liegt, so wird der Initialisierungsvorgang ggfs. mehrfach wiederholt. Ist nach einer bestimmten Anzahl von Wiederholungen noch immer keine zulässige Senderleistung erreicht, so bedeutet dies, daß ein Fehler in der Schaltungsanordnung bzw. den zugehörigen mechanischen Komponenten vorliegt. Dann kann ein Fehlersignal abgegeben werden.

Nach einem weiteren Merkmal der Erfindung wird vorgesehen, daß der Initialisierungsvorgang innerhalb größerer Zeitabstände nach der Erstinstallation automatisch wiederholt wird. Durch diese Wiederholung in größeren Zeitabständen, beispielsweise alle 14 Tage, erfolgt eine Selbstadaption der Schaltungsanordnung an sich kontinuierlich verändernde Vorgänge, z.B. an eine Farbänderung der stationär vorhandenen Objekte, die mit einer Veränderung des Reflexionsvermögens einhergehen, an eine Alterung der elektronischen Komponenten der Schaltungsanordnung selbst, oder an eine Verschmutzung der optischen Fenster oder dergleichen.

Eine erfindungsgemäße Schaltungsanordnung der eingangs genannten Art ist dadurch gekennzeichnet, daß
d) der Sender von einem Verstärker mit variabler Verstärkung gespeist wird, der einen Eingang zum Anlegen einer variablen Steuerspannung aufweist;
e) eine programmierbare Einrichtung vorgesehen ist, die ihrerseits aufweist:
   - einen Eingang (a), welchem das Ausgangssignal der Auswertschaltung zuführbar ist;
   - einen Ausgang (d), der mit dem Eingang (b) des Verstärkers (2) verbunden ist,
   wobei die programmierbare Einrichtung so programmiert ist, daß in einem Initialisierungsvorgang nach der Erstinstallation ihr an den Eingang (b) des Verstärkers abgegebenes Signal progressiv so lange in dem Sinne verändert wird, in dem sich eine Vergrößerung des Verstärkers ergibt, bis durch an einem stationär vorhandenen Objekt reflektierte Strahlung die Auswertschaltung ausgelöst wird, daß dann das an den Verstärker abgegebene Signal der programmierbaren Einrichtung geringfügig im Sinne einer Verringerung der Verstärkung zurückgenommen wird, und daß dann automatisch in den Normalbetrieb der Schaltungsanordnung bei dieser verringerten Verstärkung übergegangen wird.

Der Sinn dieser erfindungsgemäß vorgeschlagenen Maßnahmen ergibt sich entsprechend aus den oben zum erfindungsgemäßen Verfahren gemachten Erläuterungen.

Vorteilhafte Ausführungsformen der erfindungsgemäßen Schaltungsanordnung sind in den Ansprüchen 5-9 angegeben.

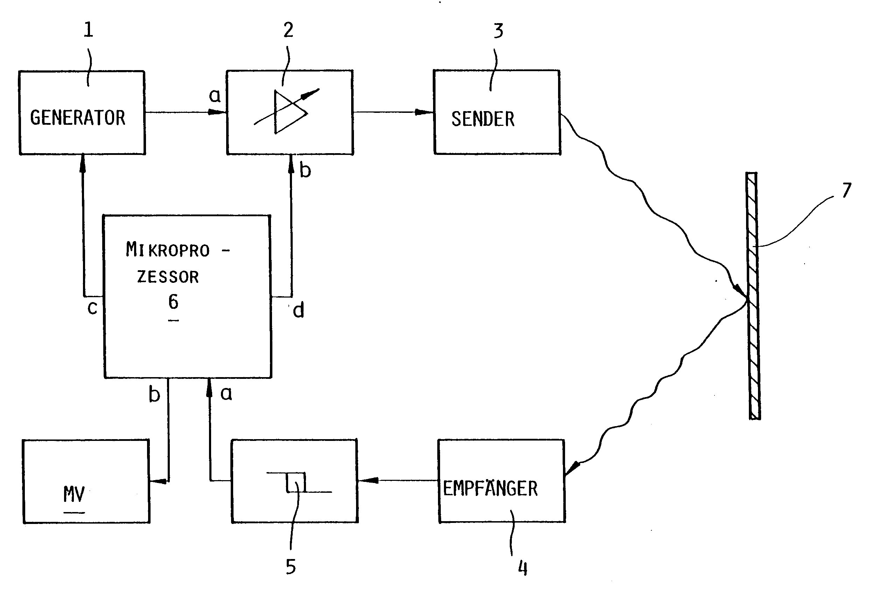

Ein Ausführungsbeispiel der Erfindung wird nachfolgend anhand der Zeichnung näher erläutert; die einzige Figur zeigt schematisch das Blockschaltbild einer Schaltungsanordnung für eine berührungslos gesteuerte Sanitärarmatur.

In der Zeichnung ist mit dem Bezugszeichen 1 ein Generator bezeichnet, der ein Ausgangssignal mit einer bestimmten Grundfrequenz, z.B. 50 kHz, erzeugt. Dieses wird in Eingang (a) eines Verstärkers 2 zugeführt, dessen Verstärkungsfaktor über ein weiteres Eingangssignal, welches am Eingang (b) liegt, geregelt werden kann. Das Ausgangssignal des Verstärkers 2 beaufschlagt den Sender 3, der mit der von dem Generator 1 vorgegebenen Frequenz eine Detektionsstrahlung aussendet. Die Art der Strahlung ist im vorliegenden Zusammenhang von untergeordneter Bedeutung; zu Beschreibungszwecken wird davon ausgegangen, daß es sich um Infrarot-Strahlung handelt. In diesem Falle befindet sich innerhalb des Senders 3 eine Sendediode.

Die von dem Sender 3 abgegebene Strahlung wird von einen Objekt 7, bei dem es sich um einen Benutzer, aber auch um einen ortsfesten Gegenstand, z.B. einen Waschtisch, handeln kann, zurück auf einen Empfänger 4 reflektiert. Bei Verwendung von Infrarotlicht enthält der Empfänger 4 eine Empfangsdiode. Das Ausgangssignal des Empfängers 4 wird einem Impulsformer 5 zugeführt, der einen schmalbandigen, auf die Frequenz des Generators 1 abgestimmten Verstärker sowie einen Schmitt-Trigger enthält. Sobald das Eingangssignal an dem Impulsformer 5, soweit es innerhalb des fraglichen Frequenzbandes liegt, einen bestimmten Schwellwert übersteigt, ändert sich das Ausgangspotential des Impulsformers 5 von einem zu einem anderen Wert.

Der Ausgang des Impulsformers 5 ist mit einem Eingang a eines Mikroprozessors 6 verbunden. Dieser besitzt außerdem die Ausgänge b, c und d.

An den Ausgang b des Mikroprozessors 6 ist die Treiberschaltung für das Magnetventil MV angeschlossen, welches den Wasserfluß der Sanitärarmatur steuert. Der Ausgang c ist mit dem Generator 1 verbunden. Der Ausgang d schließlich ist mit dem Steuereingang b des regelbaren Verstärkers 2 verbunden.

Die Funktionsweise der beschriebenen Schaltungsanordnung ist wie folgt:

Wird die berührungslos gesteuerte Sanitärarmatur mit der in der Zeichnung dargestellten Schaltungsanordnung vor Ort erstmals installiert, so spielt sich z.B. nach Einschalten der Betriebsspannung innerhalb der Schaltungsanordnung zunächst ein Initialisierungsvorgang ab, welcher der richtigen Empfindlichkeitseinstellung dient. Diese Initialisierung soll sicherstellen, daß die Sanitärarmatur durch ortsfeste Objekte, z.B. das Waschbecken, an dem die Sanitärarmatur installiert ist, nicht ausgelöst wird. Die Initialisierung läuft, durch eine geeignete Programmierung des Mikroprozessors 6 gesteuert, wie folgt ab:

Der Mikroprozessor 6 gibt über seinen Ausgang c an den Generator 1 in bestimmten Zeitabständen Impulse bestimmter Breite ab. Während der Dauer dieser Impulse erzeugt der Generator 1 sein Ausgangssignal mit der oben erwähnten Taktfreqenz. Am Ausgang d stellt der Mikroprozessor 6 zunächst ein Signal mit verhältnismäßig niedrigem Pegel zur Verfügung, welches den Verstärkungsfaktor des Verstärkers 2 auf einen verhältnismäßig niedrigen Wert einstellt. Entsprechend gering ist die Leistung des Senders 3. Die Intensität der Strahlung, die von einem ortsfesten Objekt 7 auf den Empfänger 4 reflektiert wird, reicht daher zunächst noch nicht aus, den Impulsformer 5 auszulösen, so daß am Eingang a des Mikroprozessors 6 keine Veränderung des Potentials stattfindet.

In kurzen zeitlichen Abständen verändert nunmehr der Mikroprozessor 6 die Größe des Pegels, den das an seinem Ausgang d abgegebene Signal aufweist. In entsprechender Weise wird der Verstärkungsfaktor des Verstärkers 2 und damit die Leistung des Senders 3 progressiv erhöht, bis schließlich die auf den Empfänger 4 vom ortsfesten Objekt 7 zurückreflektierte Strahlung einen Wert erreicht hat, bei welchem der Impulsformer 5 auslöst und sich das Potential des am Eingang a des Mikroprozessors 6 liegenden Signales verändert.

Auf diese Änderung des Potentiales am Eingang a reagiert der Mikroprozessor 6 dadurch, daß er den Pegel des Signales, welches er am Ausgang d abgibt, wieder um einen geringen Betrag, beispielsweise um einen bestimmten Prozentsatz verringert. Hierdurch wird der Verstärkungsfaktor des Verstärkers 2 ebenfalls etwas reduziert; die Leistung des Senders 3 geht zurück, so daß die vom Empfänger 4 an den Impulsformer 5 abgegebene Signalamplitude nicht mehr zur Auslösung des Impulsformers 5 ausreicht.

Im einem in dem Mikroprozessor 6 vorhandenen Speicher ist ein Toleranzbereich von Senderleistungen bzw. zulässigen Werten des Signales am Ausgang d einprogrammiert. Liegt der in dem oben beschriebenen Initialisierungsvorgang ermittelte Wert der Senderleistung bzw. des Signales am Ausgang d innerhalb dieses Toleranzbereiches, kann die Initialisierung abgeschlossen werden. Liegt dieser Wert aber außerhalb des Toleranzbereiches, wird der Initialisierungsvorgang nocheinmal - ggfs. mehrfach - wiederholt, um so zufällige Fehlmessungen zu eliminieren. Die Zahl der Wiederholungen ist jedoch begrenzt, zum Beispiel durch Vorgabe einer kurzen Zeit, innerhalb welcher Wiederholungen durchgeführt werden. Ist auch danach noch kein zulässiger Wert der Senderleistung bzw. des Signales am Ausgang d des Mikroprozessors 6 ermittelt, wird der Initialisierungsvorgang abgebrochen und es erfolgt eine Fehlermeldung.

Ist der Initialisierungsvorgang mit der Ermittlung eines zulässigen Wertes für die Senderleistung abgeschlossen, so ist die Empfindlichkeit der Schaltungsanordnung so nahe wie möglich an den Wert herangefahren, bei dem durch ortsfeste Objekte 7 eine (unerwünschte) Auslösung eintreten würde; durch das Zurückfahren der Senderleistung wird jedoch dieer kritische Wert zuverlässig unterschritten.

Die Schaltungsanordnung und die von ihr gesteuerte Sanitärarmatur sind nunmehr zum normalen Betrieb gerüstet:

Der Generator 1 gibt in den Zeiten, die durch die von dem Mikroprozessor 6 auf dem Ausgang c abgegebenen Impulsdauern bestimmt sind, sein Taktsignal ab. Dieses wird im Verstärker 2 mit dem Verstärkungsfaktor verstärkt, der zuvor in dem oben beschriebenen Initialisierungsvorgang bestimmt und dann festgehalten wurde. Entsprechend groß ist die vom Sender 3 abgegebene Strahlungsleistung, die bekanntlich nicht dazu ausreicht, daß die jeweils vorhandenen ortsfesten Objekte 7 die Sanitärarmatur auslösen. Bewegt sich nunmehr jedoch ein anderes, nicht stationäres Objekt 7, beispielsweise die Hand eines Benutzers, näher an den Sender 3 heran, so erhöht sich die Intensität der auf den Empfänger 4 auftreffenden Strahlung. Das Ausgangssignal des Empfängers 4 löst den Impulsformer 5 aus. Die hierdurch verursachte Potentialveränderung am Eingang a des Mikroprozessors 6 hat im Normalbetrieb zur Folge, daß am Ausgang b des Mikroprozessors 6 ein Signal erscheint, welches zur Betätigung des Magnetventiles MV weiterverarbeitet werden kann. Das Wasser beginnt zu fließen, solange das bewegliche Objekt 7 ausreichend Licht auf den Empfänger 4 zurückreflektiert. Entfernt sich das bewegliche Objekt 7 aus dem Empfindlichkeitsbereich der Schaltungsanordnung heraus, so fällt der Impulsformer 5 ab, da er vom Empfänger 4 kein Signal ausreichender Amplitude innerhalb des vorgegebenen Frequenzbandes mehr empfängt. Das Potential am Eingang a des Mikroprozessors 6 kehrt wieder auf seinen ursprünglichen Wert zurück. Die Bestromung des Magnetventiles MV wird beendet.

Der oben beschriebene Initialisierungsvorgang wird nicht nur bei der erstmaligen Montage (Erstinstallation) der Sanitärarmatur und der Schaltungsanordnung vor Ort durchgeführt. Um Alterungsvorgänge bzw. Veränderungen in der Umgebung der Sanitärarmatur erfassen zu können, wird der Initialisierungsvorgang in bestimmten zeitlichen Abständen, z.B. alle 14 Tage, automatisch wiederholt.

Befindet sich bei bestimmten Installationen, z.B. bei Duschen, innerhalb der näheren Umgebung von Sender 3 und Empfänger 4 kein ortsfestes Objekt 7, an welchem die zur Durchführung des Initialisierungsvorganges erforderliche Reflexion stattfinden kann, so wird dieses ortsfeste Objekt 7 durch die innere Fläche des optischen Fensters ersetzt, welches vor dem mit dem Empfänger 4 zu einer Einheit zusammengefaßten Sender 3 montiert ist. An dieser inneren Fläche findet immer eine (wenn auch vergleichsweise geringe) Reflexion der vom Sender 3 ausgesandten Strahlung statt. Ein Teil dieser reflektierten Strahlung gelangt auch auf den Empfänger 4. Die Anhebung des Pegels, den der Mikroprozessor 6 an seinem Ausgang d bereitstellt, und damit die Größe des Verstärkungsfaktors des Verstärkers 2 und die Leistung des Senders 3 erreichen also spätestens dann ihr Maximum, wenn die vom optischen Fenster auf den Empfänger 4 zurückreflektierte Strahlung ausreicht, den Impulsformer 5 auszulösen. Stellt der Mikroprozessor 6 auch bei sehr hohen Leistungen des Senders 3 keine Potentialveränderung an seinem Eingang a fest, so deutet er dies als Systemfehler (z.B. kann das optische Fenster beschädigt sein) und gibt einen entsprechenden Alarm.

Um sicherzustellen, daß zu dem genannten Zweck von dem optischen Fenster eine ausreichende Strahlungsintensität auf den Empfänger 4 zurückreflektiert wird, wird die Strahlung des Senders 3 mit spitzem Einfallswinkel, also nicht senkrecht, durch das optische Fenster hindurchgeleitet.

## Patentansprüche

1. Verfahren zum Betreiben einer Schaltungsanordnung für eine berührungslos gesteuerte Sanitärarmatur mit einem Sender, mit einem Empfänger, auf welchen vom Sender ausgesandte Strahlung an einem Objekt zurückreflektierbar ist, und mit einer dem Empfänger nachgeschalteten Auswertschaltung, die ein Ausgangssignal abgibt, wenn das vom Empfänger abgegebene Signal einen bestimmten Schwellwert übersteigt,
dadurch gekennzeichnet, daß
bei der Erstinstallation der Schaltungsanordnung ein Initialisierungsvorgang eingeleitet und durchgeführt wird, in dessen Verlauf die Leistung des Senders (3) progressiv gesteigert wird, bis durch an einem stationär vorhandenen Objekt (7) reflektierte Strahlung die Auswertschaltung (5) anspricht, daß daraufhin die Leistung des Senders (3) wieder etwas reduziert wird und danach bei dieser verminderten Leistung des Senders (3) in den Normalbetrieb übergegangen wird.

2. Verfahren nach Anspruch 1, dadurch gekennzeichnet, daß der bei dem Initialisierungsvorgang ermittelte Wert der Leistung des Senders (3) mit einem vorgegebenen Toleranzbereich verglichen wird, innerhalb dessen sich die Leistung bei normaler Funktion der Schaltungsanordnung befinden muß, und daß der Initialisierungsvorgang ggfs. mehrfach wiederholt wird, wenn der ermittelte Wert der Leistung des Senders (3) nicht innerhalb des Toleranzbereiches liegt.

3. Verfahren nach Anspruch 1 oder 2, dadurch gekennzeichnet, daß der Initialisierungsvorgang innerhalb größerer Zeitabstände nach der Erstinstallation automatisch wiederholt wird.

4. Schaltungsanordnung für eine berührungslos gesteuerte Sanitärarmatur mit
a) einem Sender, der eine Strahlung aussendet;
b) einem Empfänger, der die an einem Objekt reflektierte Strahlung des Senders empfängt;
c) einer dem Empfänger nachgeschalteten Auswertschaltung, die ein Ausgangssignal abgibt, wenn das von dem Empfänger abgegebene Signal einen bestimmten Schwellwert übersteigt,
dadurch gekennzeichnet, daß
d) der Sender (3) von einem Verstärker (2) mit variabler Verstärkung gespeist wird, der einen Eingang (b) zum Anlegen einer variablen Steuerspannung aufweist;
e) eine programmierbare Einrichtung (6) vorgesehen ist, die ihrerseits aufweist:
- einen Eingang (a), welchem das Ausgangssignal der Auswertschaltung (5) zuführbar ist;
- einen Ausgang (d), der mit dem Eingang (b) des Verstärkers (2) verbunden ist,
wobei die programmierbare Einrichtung (6) so programmiert ist, daß in einem Initialisierungsvorgang unmittelbar nach der Erstinstallation ihr an den Eingang (b) des Verstärkers (2) abgegebenes Signal so lange in dem Sinne verändert wird, in dem sich eine Vergrößerung der Verstärkung ergibt, bis durch an einem stationär vorhandenen Objekt (7) reflektierte Strahlung die Auswertschaltung (5) ausgelöst wird, daß dann das an den Verstärker (2) abgegebene Signal der programmierbaren Einrichtung (6) geringfügig im Sinner einer Verringerung der Verstärkung zurückgenommen wird, und daß dann in den Normalbetrieb der Schaltungsanordnung bei dieser verringerten Verstärkung übergegangen wird.

5. Schaltungsanordnung nach Anspruch 4, dadurch gekennzeichnet, daß in der programmierbaren Einrichtung (6) ein Speicher, in welchem ein zulässiger Bereich von Signalen am Ausgang (a) abgelegt ist, sowie ein Komparator vorgesehen sind, welcher den in dem Initialisierungsvorgang ermittelten Wert des Signales am Ausgang (a) mit dem abgespeicherten, zulässigen Bereich vergleicht.

6. Schaltungsanordnung nach Anspruch 4 oder 5, dadurch gekennzeichnet, daß die programmierbare Einrichtung (6) so programmiert ist, daß der Initialisierungsvorgang innerhalb kurzer Zeit mehrfach wiederholt wird, wenn kein innerhalb eines zulässigen Bereiches liegender Wert des Signales am Ausgang (a) ermittelt wird.

7. Schaltungsanordnung nach einem der Ansprüche 4-6, dadurch gekennzeichnet, daß die programmierbare Einrichtung (6) so programmiert ist, daß der Initialisierungsvorgang in größeren zeitlichen Abständen nach der Erstinstallation wiederholt wird.

8. Schaltungsanordnung nach einem der Ansprüche 4-7, dadurch gekennzeichnet, daß die programmierbare Einrichtung (6) an einem Ausgang (c) Impulse einstellbarer Dauer und Folge abgibt, während denen der Verstärker (2) den Sender (3) beaufschlagt.

9. Schaltungsanordnung nach einem der Ansprüche 4-8, dadurch gekennzeichnet, daß die programmierbare Einrichtung (6) ein Mikroprozessor ist.

## Claims

1. Method of operating a circuit arrangement for a proximity controlled sanitary fitting, comprising an emitter, a receiver to which radiation emitted by the emitter can be reflected from an object, and comprising an evaluation circuit which is connected downstream of the receiver and which emits an output signal when the signal emitted by the receiver exceeds a certain threshold value,
characterised in that,
upon initial installation of the circuit arrangement, an initialisation procedure is initiated and carried out, in the course of which the output of the emitter (3) is progressively increased until the evaluation circuit (5) responds as a result of radiation reflected by a stationary object (7), thereupon the output of the emitter (3) is reduced again slightly and thereafter normal operation is begun at that reduced output of the emitter (3).

2. Method according to claim 1, characterised in that the value of the output of the emitter (3) determined in the initialisation procedure is compared with a specified tolerance range within which the output must lie when the circuit arrangement is functioning normally, and the initialisation procedure is repeated, if necessary several times, if the value of the output of the emitter (3) determined does not lie within the tolerance range.

3. Method according to claim 1 or 2, characterised in that the initialisation procedure is automatically repeated at relatively long intervals after the initial installation.

4. Circuit arrangement for a proximity controlled sanitary fitting comprising
a) an emitter which emits radiation;
b) a receiver which receives the radiation of the emitter reflected by an object;
c) an evaluation circuit which is connected downstream of the receiver and which emits an output signal when the signal emitted by the receiver exceeds a certain threshold value,
characterised in that
d) the emitter (3) is fed by a variable amplification amplifier (2) having one input (b) for applying a variable control voltage;
e) a programmable device (6) is provided which in turn comprises:
- an input (a) to which the output signal of the evaluation circuit (5) can be supplied;
- an output (d) which is connected to the input (b) of the amplifier (2),
wherein the programmable device (6) is so programmed that, in an initialisation procedure immediately following the initial installation, its output signal transmitted to the input (b) of the amplifier (2) is progressively varied in the direction in which an increase in the amplification is produced, until the evaluation circuit (5) is triggered by radiation reflected by a stationary object (7) present, the signal of the programmable device (6) transmitted to the amplifier (2) is then taken down slightly in the direction of a reduction in the amplification, and then normal operation of the circuit arrangement is begun at that reduced amplification.

5. Circuit arrangement according to claim 4, characterised in that there are provided in the programmable device (6) a memory in which a permissible range of signals at the output (a) is stored, and a comparator which compares the value of the signal at the output (a) determined in the initialisation procedure with the stored, permissible range.

6. Circuit arrangement according to claim 4 or 5, characterised in that the programmable device (6) is so programmed that the initialisation procedure is repeated several times within a short time if no value of the signal at the output (a) lying within a permissible range is determined.

7. Circuit arrangement according to any one of claims 4 to 6, characterised in that the programmable device (6) is so programmed that the initialisation procedure is repeated at relatively long intervals after the initial installation.

8. Circuit arrangement according to any one of claims 4 to 7, characterised in that the programmable device (6) emits pulses of a variable length and sequence at one output (c), during which pulses the amplifier (2) acts on the emitter (3).

9. Circuit arrangement according to any one of claims 4 to 8, characterised in that the programmable device (6) is a microprocessor.

## Revendications

1. Procédé pour actionner un circuit pour une robinetterie sanitaire commandée sans contact, comprenant un émetteur, un récepteur sur lequel un rayon émis par l'émetteur peut être réfléchi par un objet, et un circuit d'évaluation monté en aval du récepteur, qui fournit un signal de sortie lorsque le signal fourni par le récepteur dépasse une certaine valeur seuil, caractérisé en ce que, lors de la première installation du circuit, on amorce et on met en oeuvre un processus d'initialisation au cours duquel on augmente progressivement la puissance de l'émetteur (3), jusqu'à ce que le rayon réfléchi sur un objet (7) fixe sollicite le circuit d'évaluation (5), en ce qu'ensuite la puissance de l'émetteur (3) est à nouveau légèrement réduite, avant de passer en fonctionnement normal lorsque l'émetteur (3) fonctionne à cette puissance réduite.

2. Procédé selon la revendication 1, caractérisé en ce que la valeur de la puissance de l'émetteur (3) qui a été déterminée lors du processus d'initialisation est comparée à un domaine de tolérances préalablement donné, à l'intérieur duquel doit se situer la puissance lorsque le circuit fonctionne normalement, et en ce que le processus d'initialisation est éventuellement répété à plusieurs reprises lorsque la valeur de la puissance de l'émetteur (3) ne se situe pas à l'intérieur du domaine de tolérances.

3. Procédé selon la revendication 1 ou 2, caractérisé en ce que le processus d'initialisation est automatiquement répété à intervalles de temps plus importants après la première installation.

4. Circuit pour une robinetterie sanitaire commandée sans contact comprenant:
a) un émetteur qui émet un rayon;
b) un récepteur qui reçoit le rayon de l'émetteur réfléchi par un objet;
c) un circuit d'évaluation monté en aval du récepteur, qui fournit un signal de sortie lorsque le signal fourni par le récepteur dépasse une certaine valeur seuil,
caractérisé en ce que
d) I'émetteur (3) est alimenté par un amplificateur (2) à amplification variable qui présente une entrée (b) pour y appliquer une tension de commande variable;
e) un dispositif programmable (6) est prévu, qui quant à lui présente :
- une entrée (a) à laquelle peut être amené le signal de sortie du circuit d'évaluation (5);
- une sortie (d) qui est reliée à l'entrée (b) de l'amplificateur (2),
le dispositif programmable (6) étant programmé de telle manière que le signal qu'il fournit à l'entrée (b) de l'amplificateur (2) directement après la première installation au cours d'un processus d'initialisation soit modifié pour augmenter l'amplification jusqu'à ce que le rayon réfléchi par un objet (7) présent de façon stationnaire déclenche le circuit d'évaluation (5), qu'ensuite le signal que le dispositif programmable (6) fournit à l'amplificateur (2) soit légèrement réduit au sens d'une diminution de l'amplification, et qu'ensuite le circuit passe en fonctionnement normal avec cette amplification réduite.

5. Circuit selon la revendication 4, caractérisé en ce que sont prévus dans le dispositif programmable (6) une mémoire dans laquelle est enregistré un domaine autorisé pour le signal à la sortie (a), ainsi qu'un comparateur qui compare la valeur du signal à la sortie (a) qui a été déterminée au cours du processus d'initialisation avec le domaine autorisé enregistré.

6. Circuit selon la revendication 4 ou 5, caractérisé en ce que le dispositif programmable (6) est programmé de telle façon que le processus d'initialisation soit répété à plusieurs reprises en peu de temps lorsqu'aucune valeur située dans un domaine autorisé n'a été établie pour le signal à la sortie (a).

7. Circuit selon l'une des revendications 4 à 6, caractérisé en ce que le dispositif programmable (6) est programmé de telle manière que le processus d'initialisation soit répété à intervalles de temps plus importants après la première initialisation.

8. Circuit selon l'une des revendications 4 à 7, caractérisé en ce que le dispositif programmable (6) fournit à une sortie (c) des impulsions d'une durée et d'une fréquence variables, au cours desquelles l'amplificateur (2) sollicite l'émetteur (3).

9. Circuit selon l'une des revendications 4 à 8, caractérisé en ce que le dispositif programmable (6) est un microprocesseur.
